# EUROPEAN PATENT APPLICATION

(11) **EP 4 760 306 A1**
(43) Date of publication of application: **17.06.2026**
(21) Application number: 25810154.2
(22) Date of filing: 07.05.2025
(51) Int. Cl.: G01R 31/389, G01R 31/3842, G01R 31/396, G01R 27/08, G01R 31/392, G01R 19/10, G01R 19/165

(54) **APPARATUS AND METHOD FOR DIAGNOSING BATTERY**

(30) Priority: 10.05.2024 KR 20240061803
(71) Applicant: LG Energy Solution, Ltd., Seoul 07335 (KR)
(72) Inventor: CHOI, Dong-In, Daejeon 34122 (KR); YU, Hye-In, Daejeon 34122 (KR)
(74) Representative: Goddar, Heinz J.
(86) International application number: PCT/KR2025/006117
(87) International publication number: WO 2025/234752

(57) **Abstract**

An apparatus for diagnosing a battery according to an embodiment of the present disclosure comprises a profile obtaining unit configured to obtain a charging profile representing a voltage change of a battery in a charging process; and a control unit configured to calculate a voltage change amount of the battery at a charging start point of the charging profile, calculate a target resistance of the battery based on the calculated voltage change amount, and diagnose a state of the battery by comparing the target resistance with a first resistance profile in which a target resistance of the battery calculated in a previous charging cycle is stored.

## Description

### TECHNICAL FIELD

This application is based on and claims priority from Korean Patent Application No. 10-2024-0061803, filed on May 10, 2024, with the Korean Intellectual Property Office, the disclosure of which is incorporated herein in its entirety by reference.

The present disclosure relates to an apparatus and method for diagnosing a battery, and more particularly, to an apparatus and method for diagnosing a battery, which diagnoses a state of a battery based on resistance generated during a charging process.

### BACKGROUND ART

Recently, the demand for portable electronic products such as notebook computers, video cameras and portable telephones has increased sharply, and electric vehicles, energy storage batteries, robots, satellites and the like have been developed in earnest. Accordingly, high-performance batteries allowing repeated charging and discharging are being actively studied.

Batteries commercially available at present include nickel-cadmium batteries, nickel hydrogen batteries, nickel-zinc batteries, lithium batteries and the like. Among them, the lithium batteries are in the limelight since they have almost no memory effect compared to nickel-based batteries and also have very low self-charging rate and high energy density.

Although much research is being conducted on these batteries in terms of high capacity and high density, improving lifespan and safety is also important. In order to improve battery safety, technology that accurately diagnoses the current state of the battery is required.

In particular, it is necessary to prevent the phenomenon of lithium deposition on the surface of the negative electrode (lithium plating). If lithium is deposited on the surface of the negative electrode, it causes side reactions with the electrolyte and changes in the kinetic balance of the battery, which causes battery deterioration.

In addition, lithium plating may cause swelling of the battery. When swelling occurs in the battery, the center of the battery swells more than the edges of the battery, which may cause an uneven pressure distribution in the battery. This may cause problems such as a decrease in battery performance and a sudden death phenomenon in which the electrical connection is momentarily disconnected.

### DISCLOSURE

### Technical Problem

The present disclosure is designed to solve the problems of the related art, and therefore the present disclosure is directed to providing an apparatus and method for diagnosing a battery, which diagnoses a state of a battery having a risk of sudden death based on the resistance of the battery calculated in a charging process.

These and other objects and advantages of the present disclosure may be understood from the following detailed description and will become more fully apparent from the exemplary embodiments of the present disclosure. Also, it will be easily understood that the objects and advantages of the present disclosure may be realized by the means shown in the appended claims and combinations thereof.

### Technical Solution

An apparatus for diagnosing a battery according to one aspect of the present disclosure may comprise a profile obtaining unit configured to obtain a charging profile representing a voltage change of a battery in a charging process; and a control unit configured to calculate a voltage change amount of the battery at a charging start point of the charging profile, calculate a target resistance of the battery based on the calculated voltage change amount and an initial SOC of the battery at the charging start point, and diagnose a state of the battery by comparing the target resistance with a first resistance profile in which a target resistance of the battery calculated in a previous charging cycle is stored.

The control unit may be configured to calculate an initial resistance based on the voltage change amount and a charging current of the charging process.

The control unit may be configured to determine the initial resistance as the target resistance, when the initial SOC is equal to a preset target SOC.

The control unit may be configured to calculate the target resistance from the initial resistance based on a resistance table preset to represent a resistance ratio for each SOC, when the initial SOC is different from the target SOC.

The resistance table may be preset to correspond to a plurality of reference values for a preset reference factor.

The control unit may be configured to calculate the target resistance based on a resistance table corresponding to a state value of the battery, when a state value of the battery for the reference factor is identical to any one of the plurality of reference values.

The control unit may be configured to select a plurality of target values adjacent to the state value of the battery among the plurality of reference values when the state value of the battery is different from the plurality of reference values, generate a target resistance table from a resistance table corresponding to the plurality of target values, and calculate the target resistance based on the target resistance table.

The control unit may be configured to calculate a total resistance for the battery by dividing the initial resistance by a resistance ratio corresponding to the initial SOC in the resistance table, and calculate the target resistance for the battery by multiplying the total resistance by a resistance ratio corresponding to the target SOC in the resistance table.

The control unit may be configured to determine a first resistance section based on the first resistance profile and diagnose the state of the battery by comparing the first resistance section with the target resistance.

The control unit may be configured to determine a first resistance line for a plurality of resistances included in the first resistance profile, and determine the first resistance section by adding a preset resistance threshold value to the determined first resistance line.

The control unit may be configured to diagnose the state of the battery as a normal state when the target resistance belongs to the first resistance section.

The control unit may be configured to diagnose the state of the battery as an abnormal state when the target resistance does not belong to the first resistance section.

The control unit may be configured to calculate a sub-voltage change amount between a voltage of the battery immediately after the charging starts and a voltage at time when the charging has been in progress for a preset time in the charging profile, calculate a sub-resistance of the battery based on the calculated sub-voltage change amount, and diagnose the state of the battery based on the target resistance and the sub-resistance.

The control unit may be configured to determine a second resistance section based on a second resistance profile in which a sub-resistance of the battery calculated from the previous charging cycle is stored, and diagnose the state of the battery based on the result of comparing the first resistance section with the target resistance and the result of comparing the second resistance section with the sub-resistance.

The control unit may be configured to determine a second resistance line for a plurality of resistances included in the second resistance profile, and determine the second resistance section by adding a preset resistance threshold value to the determined second resistance line.

The control unit may be configured to diagnose the state of the battery as a normal state when the target resistance belongs to the first resistance section or the sub-resistance belongs to the second resistance section.

The control unit may be configured to diagnose the state of the battery as an abnormal state when the target resistance does not belong to the first resistance section and the sub-resistance does not belong to the second resistance section.

The control unit may be configured to calculate the voltage change amount by calculating a difference between an initial voltage of the battery just before the charging starts and a voltage of the battery immediately after the charging starts.

A battery pack according to another aspect of the present disclosure may comprise the apparatus for diagnosing a battery according to one aspect of the present disclosure.

A method for diagnosing a battery according to still another aspect of the present disclosure may comprise a profile obtaining step of obtaining a charging profile representing a voltage change of a battery in a charging process; a voltage change amount calculating step of calculating a voltage change amount of the battery at a charging start point of the charging profile; a target resistance calculating step of calculating a target resistance of the battery based on the calculated voltage change amount and an initial SOC of the battery at the charging start point; and a diagnosing step of diagnose a state of the battery by comparing the target resistance with a first resistance profile in which a target resistance of the battery calculated in a previous charging cycle is stored.

### Advantageous Effects

According to one aspect of the present disclosure, the apparatus for diagnosing a battery may non-destructively diagnose the state of a battery based on the resistance behavior of the battery.

In particular, the apparatus for diagnosing a battery may predict in advance whether a battery is likely to experience sudden death based on the resistance of the battery.

The effects of the present disclosure are not limited to the effects mentioned above, and other effects not mentioned will be clearly understood by those skilled in the art from the description of the claims.

### DESCRIPTION OF DRAWINGS

The accompanying drawings illustrate a preferred embodiment of the present disclosure and together with the foregoing disclosure, serve to provide further understanding of the technical features of the present disclosure, and thus, the present disclosure is not construed as being limited to the drawing.
FIG. 1 is a diagram schematically illustrating an apparatus for diagnosing a battery according to an embodiment of the present disclosure.
FIG. 2 is a drawing schematically illustrating a charging profile according to an embodiment of the present disclosure.
FIG. 3 is an enlarged view illustrating a charging protocol of FIG. 2.
FIG. 4 is a drawing that schematically illustrates a first resistance profile according to an embodiment of the present disclosure.
FIG. 5 is an enlarged view illustrating a first resistance profile of FIG. 4.
FIG. 6 is a drawing that schematically illustrates a capacity retention rate of a battery according to an embodiment of the present disclosure.
FIG. 7 is a drawing that schematically illustrates a resistance table according to an embodiment of the present disclosure.
FIG. 8 is a drawing that schematically illustrates a second resistance profile according to an embodiment of the present disclosure.
FIG. 9 is an enlarged view illustrating a second resistance profile of FIG. 8.
FIG. 10 is a drawing schematically illustrating a battery pack according to another embodiment of the present disclosure.
FIG. 11 is a drawing schematically illustrating a vehicle according to still another embodiment of the present disclosure.
FIG. 12 is a diagram schematically showing a method for diagnosing a battery according to still another embodiment of the present disclosure.

### BEST MODE

It should be understood that the terms used in the specification and the appended claims should not be construed as limited to general and dictionary meanings, but interpreted based on the meanings and concepts corresponding to technical aspects of the present disclosure on the basis of the principle that the inventor is allowed to define terms appropriately for the best explanation.

Therefore, the description proposed herein is just a preferable example for the purpose of illustrations only, not intended to limit the scope of the disclosure, so it should be understood that other equivalents and modifications could be made thereto without departing from the scope of the disclosure.

Additionally, in describing the present disclosure, when it is deemed that a detailed description of relevant known elements or functions renders the key subject matter of the present disclosure ambiguous, the detailed description is omitted herein.

The terms including the ordinal number such as "first", "second" and the like, may be used to distinguish one element from another among various elements, but not intended to limit the elements by the terms.

Throughout the specification, when a portion is referred to as "comprising" or "including" any element, it means that the portion may include other elements further, without excluding other elements, unless specifically stated otherwise.

In addition, throughout the specification, when a portion is referred to as being "connected" to another portion, it is not limited to the case that they are "directly connected", but it also includes the case where they are "indirectly connected" with another element being interposed between them.

Hereinafter, a preferred embodiment of the present disclosure will be described in detail with reference to the accompanying drawings.

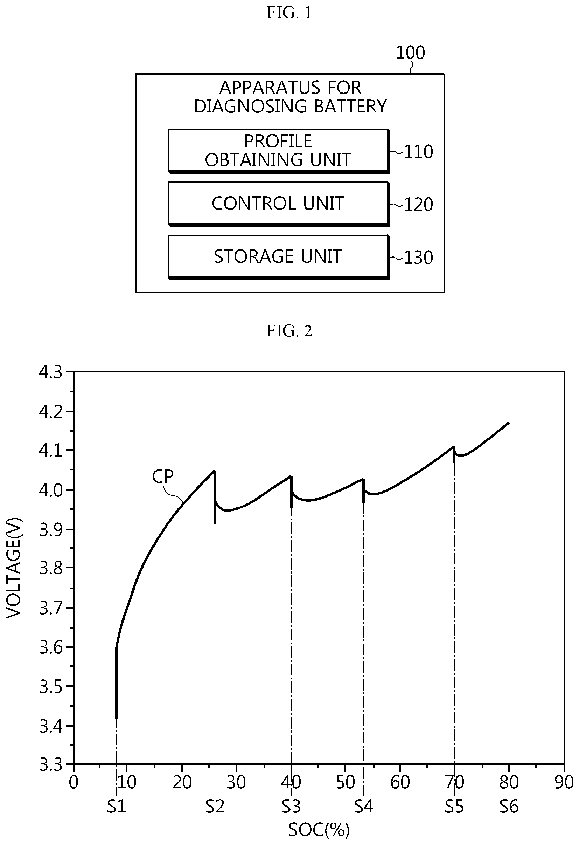

FIG. 1 is a diagram schematically illustrating an apparatus for diagnosing a battery according to an embodiment of the present disclosure.

Referring to FIG. 1, the apparatus for diagnosing a battery may include a profile obtaining unit and a control unit.

Here, the battery refers to an independent cell that has a negative terminal and a positive terminal and is physically separable. As an example, a lithium-ion battery or a lithium polymer battery may be considered as a battery. In addition, the type of batteries may be a cylindrical type, a prismatic type or a pouch type. Additionally, the battery may mean a battery bank, a battery module or a battery pack in which a plurality of cells are connected in series and/or parallel. Below, for convenience of explanation, the battery is explained as meaning one independent cell.

The profile obtaining unit 110 may be configured to obtain a charging profile CP representing a voltage change of a battery in a charging process.

Specifically, the charging profile CP may be a profile representing a change in voltage according to time or capacity of the battery from a charging start point to a charging end point in a charging process. For example, the charging profile CP may be a profile representing a corresponding relationship between charging time and voltage. As another example, the charging profile CP may be a profile representing a corresponding relationship between SOC (state of charge) and voltage. As yet another example, the charging profile CP may be a profile representing a corresponding relationship between capacity and voltage.

Here, since the charging time, the capacity according to the charging time, and the SOC according to the charging time are mutually replaceable factors for time, there is no special limitation on the charging profile CP. However, below, for the convenience of explanation, the charging profile CP is described as a profile that represents the corresponding relationship between SOC and voltage.

For example, the profile obtaining unit 110 may directly receive the charging profile CP of the battery from the outside. That is, the profile obtaining unit 110 may obtain the charging profile CP by being connected to the outside via wire and/or wirelessly and receiving the charging profile CP.

As another example, the profile obtaining unit 110 may receive battery information about the voltage and SOC of the battery. Then, the profile obtaining unit 110 may generate a charging profile CP based on the received battery information. That is, the profile obtaining unit 110 may obtain the charging profile CP by directly generating the charging profile CP based on the battery information.

FIG. 2 is a drawing schematically illustrating a charging profile CP according to an embodiment of the present disclosure. In the embodiment of FIG. 2, the charging profile CP may be expressed as an X-Y graph with the X-axis set to SOC and the Y-axis set to voltage.

Specifically, the embodiment of FIG. 2 is a charging profile CP of a battery that is rapidly charged. For example, charging of the battery starts at SOC S1 (%), and rapid charging of the battery ends at SOC S6 (%). Then, the battery is rapidly charged while the charging C-RATE decreases at SOCs S2 (%), S3 (%), S4 (%), and S5 (%). That is, the charging C-RATE of the SOC section of S1 (%) to S2 (%) is greater than the charging C-RATE of the SOC section of S2 (%) to S3 (%). The C-RATE of the SOC section of S2 (%) to S3 (%) is greater than the C-RATE of the SOC section of S3 (%) to S4 (%). The C-RATE of the SOC section of S3 (%) to S4 (%) is greater than the C-RATE of the SOC section of S4 (%) to S5 (%). The C-RATE of the SOC section of S4 (%) to S5 (%) is greater than the C-RATE of the SOC section of S5 (%) to S6 (%).

The profile obtaining unit 110 may be connected to communicate with the control unit 120. For example, the profile obtaining unit 110 may be connected to the control unit 120 by wire and/or wirelessly. The profile obtaining unit may transmit the obtained charging profile CP to the control unit 120.

The control unit 120 may be configured to calculate a voltage change amount of the battery at a charging start point of the charging profile CP.

Specifically, the battery may be in a no-load state just before charging begins. Therefore, the initial voltage of the battery just before charging begins is OCV (open circuit voltage).

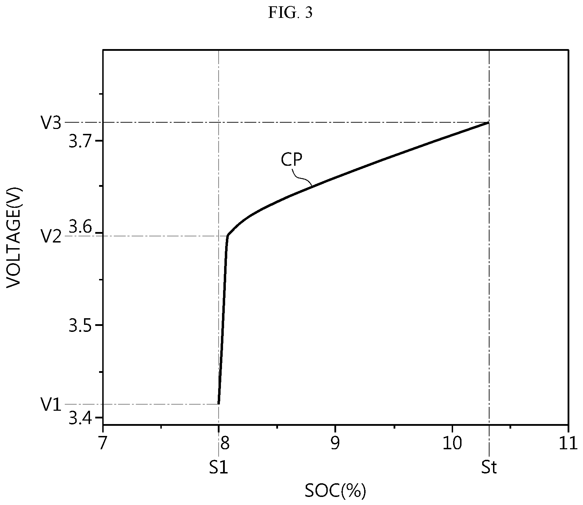

FIG. 3 is an enlarged view illustrating a charging protocol of FIG. 2. For example, the SOC of the battery just before charging begins is S1 (%) and the voltage is V1 (V).

And, when charging starts, the voltage of the battery increases rapidly compared to the initial voltage due to the internal resistance of the battery. For example, assume that the terminal voltage of the battery is V, the initial voltage is OCV, the charging current is I, and the internal resistance of the battery is R. Here, the terminal voltage of the battery may be expressed according to the formula "V = OCV + IR". That is, immediately after charging starts, the voltage of the battery may increase by "IR".

The control unit 120 may be configured to calculate a voltage change amount by calculating the difference between the initial voltage of the battery just before charging begins and the voltage of the battery immediately after charging begins.

Specifically, the control unit 120 may calculate the voltage change amount by calculating the difference between the OCV of the battery just before charging starts and the terminal voltage of the battery immediately after charging starts.

For example, in the embodiment of FIG. 3, the control unit 120 may calculate the voltage change amount by calculating the formula "V2 - V1".

The control unit 120 may be configured to calculate the target resistance of the battery based on the calculated voltage change amount and the initial SOC (State of Charge) of the battery at the charging start point.

Here, the initial SOC is the SOC corresponding to the OCV of the battery. That is, the initial SOC means the SOC of the battery at the point when charging of the battery begins.

The control unit 120 may be configured to calculate the initial resistance based on the voltage change amount and the charging current of the charging process.

Specifically, the control unit 120 may calculate the initial resistance based on the voltage change amount and the charging current using Ohm's law. For example, assume that the voltage change amount is △V and the charging current is I. The control unit 120 may calculate the initial resistance by calculating the formula "△V ÷ I".

For example, in the embodiments of FIGS. 2 and 3, it is assumed that the charging current for the SOC section of S1 (%) to S2 (%) is I. The control unit 120 may calculate the initial resistance as the value obtained by dividing the voltage change amount (V2 - V1) by the charging current (I).

Additionally, the control unit 120 may calculate the target resistance in a different manner when the initial SOC is the same as the target SOC and when it is different.

Specifically, the control unit 120 may be configured to determine the initial resistance as the target resistance when the initial SOC is equal to the preset target SOC. Conversely, the control unit 120 may be configured to calculate the target resistance from the initial resistance based on a resistance table preset to represent a resistance ratio for each SOC, when the initial SOC is different from the target SOC. A specific embodiment in which the control unit 120 calculates the target resistance will be described later.

The control unit 120 may be configured to diagnose the state of the battery by comparing the target resistance with the first resistance profile P1 in which the target resistance of the battery is stored, calculated in the previous charging cycle.

Specifically, the first resistance profile P1 is a profile in which the target resistance of the battery calculated for each previous charging cycle is stored. For example, assuming that the current cycle is the nth cycle, the target resistance calculated for the first to n-1th cycles may be stored in the first resistance profile P1. Then, when the battery state diagnosis for the nth cycle is completed, the target resistance calculated for the nth cycle may be stored in the first resistance profile P1.

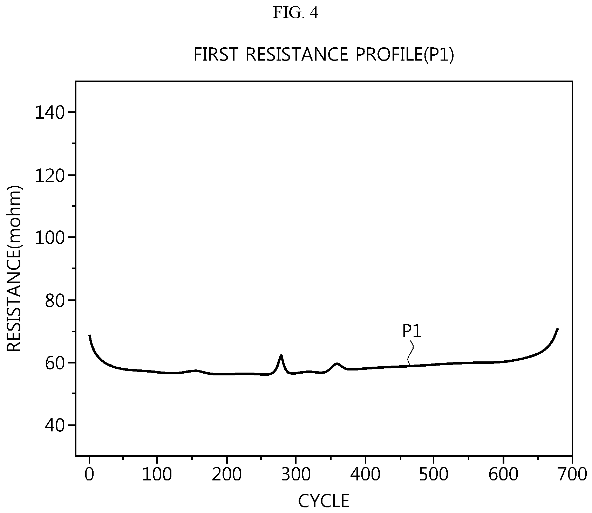

FIG. 4 is a drawing that schematically illustrates a first resistance profile P1 according to an embodiment of the present disclosure. In the embodiment of FIG. 4, the first resistance profile P1 may be expressed as an X-Y graph in which the X-axis is set to cycle and the Y-axis is set to resistance.

The control unit 120 may be configured to determine the first resistance section R1 based on the first resistance profile P1.

First, the control unit 120 may be configured to determine a first resistance line L1 for a plurality of resistances included in the first resistance profile P1.

For example, the control unit 120 may determine a first resistance line L1 for a first resistance profile P1 through regression analysis. Here, the first resistance line L1 may be linear or nonlinear.

As another example, the control unit 120 may determine the first resistance line L1 by considering the regression analysis result of the preset first reference resistance line and the first resistance profile P1 together. Here, the first reference resistance line is a resistance line derived from the first resistance profile P1 of the pre-designed reference battery. That is, the reference battery is a battery pre-designed as a normal state, and the first reference resistance line is a resistance line that may be applied to the battery in the normal state. Therefore, the control unit 120 may determine the first resistance line L1 corresponding to the first resistance profile P1 by grafting the first reference resistance line onto the regression analysis result of the first resistance profile P1.

Preferably, the control unit 120 may determine the first resistance line L1 for the first resistance profile P1 through regression analysis.

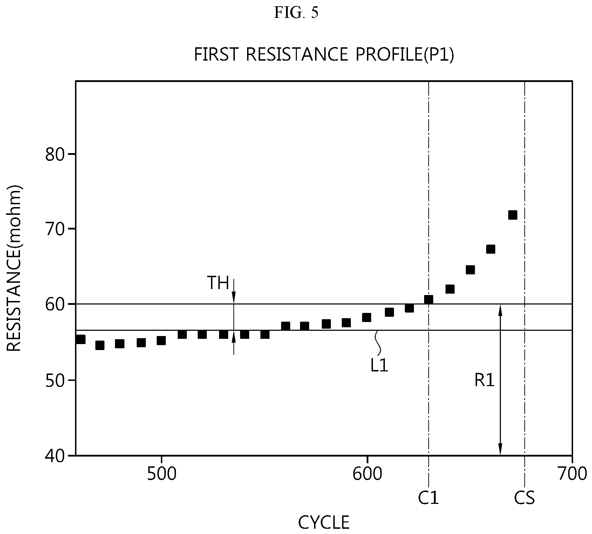

FIG. 5 is an enlarged view illustrating a first resistance profile P1 of FIG. 4. In the embodiment of FIG. 5, the control unit 120 may determine a first resistance line L1 of the first resistance profile P1.

The control unit 120 may be configured to determine the first resistance section R1 by adding a preset resistance threshold value to the determined first resistance line L1.

Specifically, the control unit 120 may adjust the first resistance line L1 by adding a preset resistance threshold value to the cycle-by-cycle resistance value according to the first resistance line L1. In addition, the control unit 120 may determine a resistance section equal to or smaller than the adjusted first resistance line L1 as the first resistance section R1.

For example, in the embodiment of FIG. 5, the control unit 120 may move the first resistance line L1 parallel to the Y-axis by adding a resistance threshold value TH to the cycle-by-cycle resistance value of the first resistance line L1. In addition, the control unit 120 may determine the resistance section equal to or smaller than the first resistance line L1 as the first resistance section R1.

In addition, the control unit 120 may be configured to diagnose the state of the battery by comparing the first resistance section R1 with the target resistance.

Specifically, the control unit 120 may diagnose the state of the battery depending on whether the target resistance belongs to the first resistance section R1.

First, if the resistance value of the target resistance is lower than or equal to the resistance value of the first resistance line L1, the control unit 120 may determine that the target resistance belongs to the first resistance section R1. Conversely, if the resistance value of the target resistance exceeds the resistance value of the first resistance line L1, the control unit 120 may determine that the target resistance does not belong to the first resistance section R1.

For example, the control unit 120 may be configured to diagnose the state of the battery as a normal state if the target resistance belongs to the first resistance section R1.

As another example, the control unit 120 may be configured to diagnose the state of the battery as an abnormal state if the target resistance does not belong to the first resistance section R1.

Here, the normal state means a state in which sudden death is unlikely to occur. And, the abnormal state means a state in which sudden death is highly predicted to occur. In other words, a battery diagnosed as in an abnormal state may be a battery in which sudden death is very likely to occur.

In general, when rapid charging is performed frequently, lithium plating phenomenon, in which lithium metal is deposited on the negative electrode surface, may occur more frequently than when normal charging is performed. In addition, since internal short circuit, fire, explosion, or sudden death that may appear due to lithium plating may occur suddenly, it is important to identify the warning symptoms in advance.

In particular, before sudden death occurs, the liquid diffusion resistance of lithium ions may increase significantly as byproducts accumulate at the interface between the negative electrode and the separator, clogging the pores of the separator and depleting the electrolyte. Since an increase in the liquid diffusion resistance is indicated by an increase in the target resistance, the control unit 120 may determine the possibility of sudden death of the battery based on whether the target resistance belongs to the first resistance section R1.

For example, in the embodiment of FIG. 5, the target resistance of the battery from the C1 cycle does not belong to the first resistance section R1. Therefore, the control unit 120 may diagnose the state of the battery as an abnormal state from the C1 cycle.

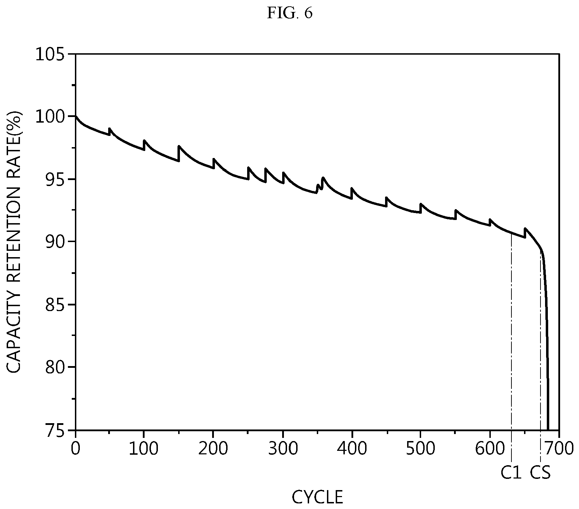

FIG. 6 is a drawing that schematically illustrates a capacity retention rate of a battery according to an embodiment of the present disclosure. Specifically, referring to FIG. 6, in the CS cycle, sudden death occurs in the battery and the capacity retention rate is dropped sharply to less than 75%. Since sudden death occurs suddenly in this way, the apparatus 100 for diagnosing a battery may predict and diagnose the possibility of sudden death in advance based on the behavior of target resistance.

Meanwhile, the control unit 120 included in the apparatus 100 for diagnosing a battery may optionally include processors, application-specific integrated circuits (ASICs), other chipsets, logic circuits, registers, communication modems, data processing devices, etc. known in the art to execute various control logics performed in the present disclosure. Also, when the control logic is implemented as software, the control unit 120 may be implemented as a set of program modules. At this time, the program module may be stored in the memory and executed by the control unit 120. The memory may be inside or outside the control unit 120 and may be connected to the control unit 120 by various well-known means.

In addition, the apparatus 100 for diagnosing a battery may further include a storage unit 130. The storage unit 130 may store data necessary for operation and function of each component of the apparatus 100 for diagnosing a battery, data generated in the process of performing the operation or function, or the like. The storage unit 130 is not particularly limited in its kind as long as it is a known information storage means that can record, erase, update and read data. As an example, the information storage means may include RAM, flash memory, ROM, EEPROM, registers, and the like. In addition, the storage unit 130 may store program codes in which processes executable by the control unit 120 are defined.

For example, the storage unit 130 may store various information used for diagnosing the state of the battery, such as the charging profile CP, the first resistance profile P1, the first resistance line L1, the resistance threshold value TH, and the first resistance section R1.

Below, an embodiment is described in which the control unit 120 calculates the target resistance when the SOC of the charging start point of the battery is not constant for each cycle. That is, an embodiment is described in which the target resistance is calculated when the initial SOC is different from the target SOC.

The control unit 120 may be configured to calculate the initial resistance based on the voltage change amount and the charging current of the charging process.

Additionally, the control unit 120 may be configured to compare the initial SOC of the battery just before charging begins with a preset target SOC.

Specifically, the target SOC may be preset to any one of the available SOC sections of the battery. For example, the target SOC may be preset to SOC 10%.

Depending on the situation in which the battery is used, the initial SOC of the battery just before charging begins may vary. For example, in the nth cycle, the battery may be charged from 8% SOC, and in the n+1th cycle, the battery may be charged from 15% SOC. Therefore, in order to more accurately calculate the target resistance, the control unit 120 may compare the initial SOC of the battery in the current cycle with the target SOC.

The control unit 120 may be configured to calculate the target resistance based on the initial resistance according to the comparison results.

If the initial SOC is equal to the target SOC, the control unit 120 may be configured to determine the initial resistance as the target resistance.

Specifically, the control unit 120 may be configured to calculate the voltage change amount by calculating a difference between the initial voltage of the battery just before charging begins and the voltage of the battery immediately after charging begins. Then, the control unit 120 may calculate the initial resistance by dividing the calculated voltage change amount by the charging current. Finally, the control unit 120 may determine the calculated initial resistance as the target resistance of the battery.

If the initial SOC is different from the target SOC, the control unit 120 may be configured to calculate the target resistance from the initial resistance based on a resistance table T preset to represent a resistance ratio for each SOC.

Specifically, the control unit 120 may convert the initial resistance corresponding to the initial SOC into the target resistance corresponding to the target SOC based on the preset resistance table T.

More specifically, the control unit 120 may be configured to calculate the total resistance for the battery by dividing the initial resistance by a resistance ratio corresponding to the initial SOC in the resistance table T. In addition, the control unit 120 may be configured to calculate the target resistance for the battery by multiplying the calculated total resistance by a resistance ratio corresponding to the target SOC in the resistance table T.

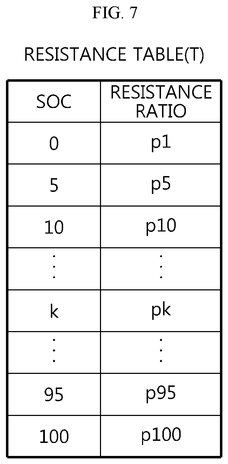

FIG. 7 is a drawing that schematically illustrates a resistance table T according to an embodiment of the present disclosure. In the embodiment of FIG. 7, the sum of the resistance ratios of p1 to p100 is 1 or 100%.

Meanwhile, in the embodiment of FIG. 7, the resistance table T is set at 5% SOC intervals, but the SOC interval in the resistance table T may be applied without limitation. Furthermore, the resistance ratio for the SOC (e.g., 3%) not included in the resistance table T may be interpolated and utilized based on the resistance ratios (p1 and p5) of the adjacent SOCs (e.g., 0% and 5%).

In the embodiment of FIG. 7, it is assumed that the preset target SOC is 10%, the initial SOC of the battery is k%, and the initial resistance is R. The control unit 120 may calculate the total resistance of the battery by dividing the initial resistance R by the resistance ratio pk of the initial SOC. For example, the control unit 120 may calculate the total resistance of the battery by calculating the formula "R ÷ pk". In addition, the control unit 120 may calculate the target resistance of the battery by multiplying the total resistance of the battery by the resistance ratio p10 of the target SOC. For example, the control unit 120 may calculate the target resistance of the battery by calculating the formula "R ÷ pk × p10".

That is, the control unit 120 may convert the initial resistance R corresponding to the initial SOC k (%) into the target resistance (R ÷ pk × p10) corresponding to the target SOC 10 (%). Then, the control unit 120 may diagnose the state of the battery based on the result of comparing the target resistance and the first resistance section R1.

The apparatus 100 for diagnosing a battery according to an embodiment of the present disclosure may calculate the target resistance by considering a situation in which the initial SOC of the battery is not constant, and diagnose the state of the battery according to the calculated target resistance. That is, the apparatus 100 for diagnosing a battery has an advantage in that it may diagnose the state of the battery even in a situation in which the initial SOC of the battery is not constant for each cycle by calculating the target resistance using the resistance table T.

Specifically, the resistance table may be preset to correspond to a reference factor that may distinguish and represent the state of the battery. Here, the reference factor may be preset as SOH (State of Health), SOP (State of Power), resistance, temperature, or cycle. Preferably, the reference factor may be applied without limitation as long as it is a factor that can be derived from values that may be measured and/or estimated from the battery using artificial intelligence technology and machine learning technology.

Below, an embodiment in which the reference factor is set to SOH is described.

Preferably, the resistance table may be preset to correspond to a plurality of reference values for a preset reference factor.

In one embodiment, the resistance table may be preset to correspond to a plurality of reference SOHs. For example, the resistance table may be preset every arbitrary SOH n%. As a specific example, the resistance table may be preset every SOH 2%.

In addition, the control unit 120 may be configured to calculate a target resistance based on the resistance table corresponding to the state value of the battery, if the state value of the battery for a reference factor is equal to any one of the plurality of reference values.

For example, the control unit 120 may be configured to calculate a target resistance based on a resistance table corresponding to the SOH of the battery when the SOH of the battery is equal to one of a plurality of reference SOHs.

Specifically, when the SOH of the battery is included in a plurality of reference SOHs and the initial SOC of the battery is different from the target SOC, the control unit 120 may determine a resistance table corresponding to the SOH of the battery. Then, the control unit 120 may calculate the target resistance from the initial resistance based on the determined resistance table.

For example, it is assumed that a plurality of reference SOHs are set for every 2% of SOH from SOH 100%. The reference SOH may be set to 100%, 98%, 96%, etc. If the SOH of the battery is 98%, the control unit 120 may select a resistance table corresponding to SOH 98% among the resistance tables corresponding to each of the plurality of reference SOHs. In addition, if the initial SOC of the battery is different from the target SOC, the control unit 120 may calculate the target resistance from the initial resistance based on the resistance table preset to correspond to SOH 98%.

The control unit 120 may be configured to select a plurality of target values adjacent to the state value of the battery among the plurality of reference values when the state value of the battery is different from a plurality of reference values.

For example, the control unit 120 may be configured to select a plurality of target SOHs adjacent to the SOH of the battery among the plurality of reference SOHs when the SOH of the battery is different from the plurality of reference SOHs.

Specifically, when the SOH of the battery is not included in the plurality of reference SOHs, the control unit 120 may select some SOHs that are closest to the SOH of the battery among the plurality of reference SOHs as target SOHs. For example, the control unit 120 may select two SOHs that are closest to the SOH of the battery among the plurality of reference SOHs as target cycles. In the previous embodiment, when the SOH of the battery is 99%, the control unit 120 may select SOH 100% and SOH 98% as target SOHs.

The control unit 120 may be configured to generate a target resistance table from a resistance table corresponding to the plurality of target values, and calculate a target resistance based on the target resistance table.

For example, the control unit 120 may be configured to generate a target resistance table from a resistance table corresponding to the plurality of target SOHs.

Specifically, the control unit 120 may set a representative value of the resistance ratio for each SOC based on the plurality of target SOHs and generate a target resistance table including the set representative values.

For example, the control unit 120 may set the representative value based on the average value, the median value, the maximum value, the minimum value, or a combination thereof of the resistance ratios for each SOC for the plurality of target SOHs. Preferably, the control unit 120 may set the average value of the resistance ratios for each SOC for the plurality of target SOHs as the representative value.

In the above embodiment, the control unit 120 assumes that the resistance ratio of the nth SOC of SOH 100% is R100n, and that the resistance ratio of the nth SOC of SOH 98% is R98n. The control unit 120 may set the resistance ratio of the nth SOC of the target resistance table by calculating the average of R100n and R98n.

As another example, the control unit 120 may interpolate a plurality of target SOHs to generate a target resistance table corresponding to the SOH of the battery.

Specifically, it is assumed that the SOH of the battery is b%, and the plurality of target SOHs are a% and c%. The control unit 120 may calculate the resistance ratio of SOH b% by SOC by interpolating the resistance ratio of SOH a% by SOC and the resistance ratio of SOH c% by SOC by the ratio of "(b - a) ÷ (c - a) : (c - b) ÷ (c - a)".

For example, in the previous embodiment, it is assumed that the SOH of the battery is 99%. The control unit 120 may calculate the resistance ratio (R99n) of the nth SOC of SOH 99% by interpolating the resistance ratio (R98n) of the nth SOC of SOH 98% and the resistance ratio (R100n) of the nth SOC of SOH 100% at a 1 : 1 ratio. That is, the apparatus 100 for diagnosing a battery has the advantage of being able to diagnose the state of the battery more accurately by calculating the target resistance using a resistance table corresponding to the SOH of the battery.

Below, an embodiment is described in which the control unit 120 supplementarily diagnoses the state of the battery by further considering sub-resistance.

The control unit 120 may be configured to calculate the sub-voltage change amount between the voltage of the battery immediately after charging starts in the charging profile CP and the voltage at the point when charging has been in progress for a preset time.

Specifically, the preset time may be determined within the time for charging at the same charging C-RATE from the charging start point. For example, the preset time may be 30 seconds.

For example, in the embodiment of FIG. 3, the initial voltage of the battery just before charging starts is V1, the voltage of the battery right after charging starts is V2, and the voltage of the battery at the point when charging has been in progress for a preset time is V3. The control unit 120 may calculate the sub-voltage change amount of the battery by calculating the formula "V3 - V2".

The control unit 120 may be configured to calculate the sub-resistance of the battery based on the calculated sub-voltage change amount.

For example, in the embodiments of FIGS. 2 and 3, it is assumed that the charging current for the SOC section of S1 (%) to S2 (%) is I. The control unit 120 may calculate the sub-resistance as the value obtained by dividing the sub-voltage change amount (V3 - V2) by the charging current (I).

The control unit 120 may be configured to diagnose the state of the battery based on the target resistance and the sub-resistance.

The control unit 120 may be configured to determine the second resistance section R2 based on a second resistance profile P2 in which the sub-resistance of the battery calculated from a previous charging cycle is stored.

Specifically, the second resistance profile P2 is a profile in which the sub-resistance of the battery calculated for each past charging cycle is stored. For example, assuming that the current cycle is the nth cycle, the sub-resistance calculated for the first to n-1th cycles may be stored in the second resistance profile P2. Then, when the battery state diagnosis for the nth cycle is completed, the sub-resistance calculated for the nth cycle may be stored in the second resistance profile P2.

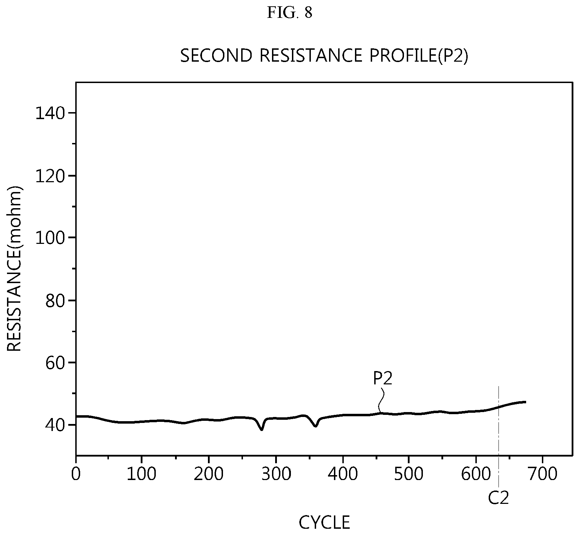

FIG. 8 is a drawing that schematically illustrates a second resistance profile P2 according to an embodiment of the present disclosure. In the embodiment of FIG. 8, the second resistance profile P2 may be expressed as an X-Y graph in which the X-axis is set to cycle and the Y-axis is set to resistance.

The control unit 120 may be configured to determine a second resistance line L2 for a plurality of resistances included in the second resistance profile P2.

For example, the control unit 120 may determine the second resistance line L2 for the second resistance profile P2 through regression analysis. Here, the second resistance line L2 may be linear or nonlinear.

As another example, the control unit 120 may determine the second resistance line L2 by considering the regression analysis result of the preset second reference resistance line and the second resistance profile P2 together. Here, the second reference resistance line is a resistance line derived from the second resistance profile P2 of a pre-designed reference battery. That is, the reference battery is a battery pre-designed in a normal state, and the second reference resistance line is a resistance line that may be applied to the battery in the normal state. Therefore, the control unit 120 may determine the second resistance line L2 corresponding to the second resistance profile P2 by grafting the second reference resistance line onto the regression analysis result of the second resistance profile P2.

Preferably, the control unit 120 may determine the second resistance line L2 for the second resistance profile P2 through regression analysis.

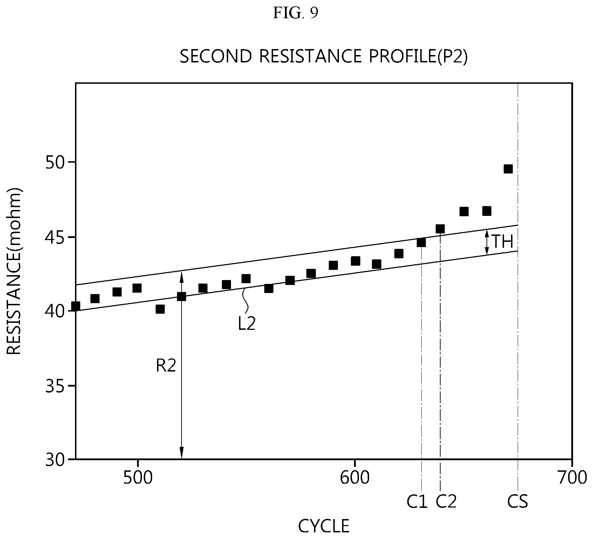

FIG. 9 is an enlarged view illustrating a second resistance profile P2 of FIG. 8. In the embodiment of FIG. 9, the control unit 120 may determine the second resistance line L2 of the second resistance profile P2.

The control unit 120 may be configured to determine the second resistance section R2 by adding a preset resistance threshold value to the determined second resistance line L2. Specifically, the control unit 120 may determine the second resistance section R2 by adding a resistance threshold value to the second resistance line L2 in the same manner as the first resistance section R1 is determined by adding a resistance threshold value to the first resistance line L1. Here, the resistance threshold value added to the first resistance line L1 and the resistance threshold value added to the second resistance line L2 may be the same as or different from each other.

For example, in the embodiment of FIG. 9, the control unit 120 may move the second resistance line L2 parallel to the Y-axis by adding the resistance threshold value TH to the cycle-by-cycle resistance value of the second resistance line L2. In addition, the control unit 120 may determine the resistance section equal to or smaller than the second resistance line L2 as the second resistance section R2.

In addition, the control unit 120 may be configured to diagnose the state of the battery based on the result of comparing the first resistance section R1 with the target resistance and the result of comparing the second resistance section R2 with the sub-resistance.

Specifically, the control unit 120 may diagnose the state of the battery based on whether the target resistance belongs to the first resistance section R1 and whether the sub-resistance belongs to the second resistance section R2.

First, if the resistance value of the target resistance is lower than or equal to the resistance value of the first resistance line L1, the control unit 120 may determine that the target resistance belongs to the first resistance section R1. Conversely, if the resistance value of the target resistance exceeds the resistance value of the first resistance line L1, the control unit 120 may determine that the target resistance does not belong to the first resistance section R1.

Next, if the resistance value of the sub-resistance is lower than or equal to the resistance value of the second resistance line L2, the control unit 120 may determine that the sub-resistance belongs to the second resistance section R2. Conversely, if the resistance value of the sub-resistance exceeds the resistance value of the second resistance line L2, the control unit 120 may determine that the sub-resistance does not belong to the second resistance section R2.

For example, the control unit 120 may be configured to diagnose the state of the battery as a normal state when the target resistance belongs to the first resistance section R1 or when the sub-resistance belongs to the second resistance section R2.

As another example, the control unit 120 may be configured to diagnose the state of the battery as an abnormal state if the target resistance does not belong to the first resistance section R1 and the sub-resistance does not belong to the second resistance section R2.

That is, the control unit 120 may diagnose the state of the battery as an abnormal state only when the target resistance does not belong to the first resistance section R1 and the sub-resistance does not belong to the second resistance section R2.

For example, in the embodiments of FIGS. 5, 6, and 9, the target resistance in the C1 cycle does not belong to the first resistance section R1, but the sub-resistance belongs to the second resistance section R2. That is, if only the target resistance is considered, the state of the battery in the C1 cycle is diagnosed as an abnormal state, but if both the target resistance and the sub-resistance are considered, the state of the battery in the C1 cycle is diagnosed as a normal state. Then, the target resistance in the C2 cycle does not belong to the first resistance section R1, and the sub-resistance does not belong to the second resistance section R2. That is, the state of the battery in the C2 cycle is diagnosed as an abnormal state. Then, sudden death occurs in the battery in the CS cycle after the C2 cycle.

When target resistance is used, the possibility of sudden death of the battery may be diagnosed earlier than when sub-resistance is used. For example, the first cycle (e.g., C1) in which the target resistance does not belong to the first resistance section R1 precedes the first cycle (e.g., C2) in which the sub-resistance does not belong to the second resistance section R2.

However, sudden death means a state in which the internal resistance of the battery increases rapidly and the battery cannot be charged or discharged, so the state of the battery should be diagnosed as an abnormal state from a conservative and strict point of view. If the state of the battery is diagnosed by considering only the target resistance, the state of the battery may be misdiagnosed, and since the state of the battery is diagnosed as an abnormal state before considering the sub-resistance, the period in which the battery can be used is shortened.

Therefore, the apparatus 100 for diagnosing a battery according to an embodiment of the present disclosure may diagnose the state of the battery more accurately by considering sub-resistance in addition to target resistance. Furthermore, the apparatus 100 for diagnosing a battery may increase the expected life of the battery by considering both target resistance and sub-resistance.

The apparatus 100 for diagnosing a battery according to the present disclosure may be applied to a battery management system (BMS). That is, the BMS according to the present disclosure may include the apparatus 100 for diagnosing a battery described above. In this configuration, at least some of components of the apparatus 100 for diagnosing a battery may be implemented by supplementing or adding functions of the components included in a conventional BMS. For example, the profile obtaining unit 110, the control unit 120 and the storage unit 130 of the apparatus 100 for diagnosing a battery may be implemented as components of the BMS.

Additionally, the apparatus 100 for diagnosing a battery according to the present disclosure may be provided in the battery pack 10. That is, the battery pack according to the present disclosure may include the above-described apparatus 100 for diagnosing a battery and at least one battery cell. Additionally, the battery pack may further include electrical components (relays, fuses, etc.) and a case.

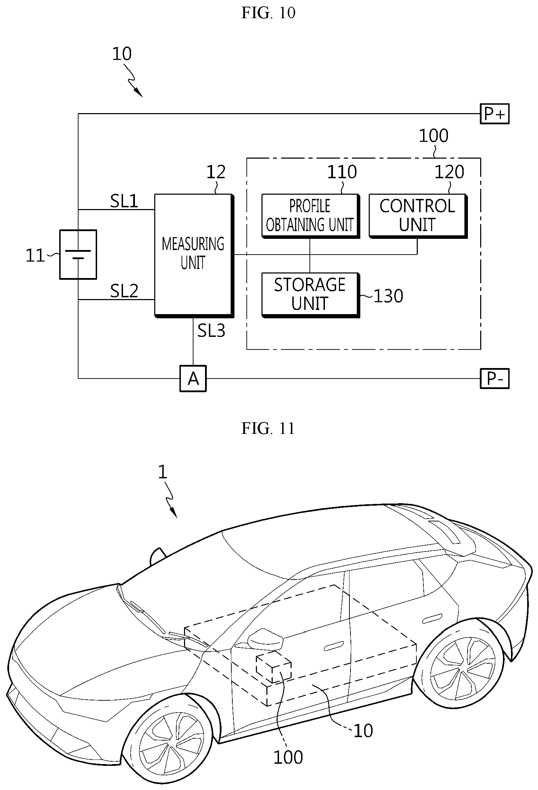

FIG. 10 is a diagram showing a battery pack according to another embodiment of the present disclosure.

The positive electrode terminal of the battery 11 may be connected to the positive electrode terminal P+ of the battery pack 10, and the negative electrode terminal of the battery 11 may be connected to the negative electrode terminal P- of the battery pack 10.

The measuring unit 12 may be connected to the first sensing line SL1, the second sensing line SL2, and the third sensing line SL3. Specifically, the measuring unit 12 may be connected to the positive electrode terminal of the battery 11 through the first sensing line SL1 and connected to the negative electrode terminal of the battery 11 through the second sensing line SL2. The measuring unit 12 may measure the voltage of the battery 11 based on the voltage measured at each of the first sensing line SL1 and the second sensing line SL2.

Also, the measuring unit 12 may be connected to the current measuring unit A through the third sensing line SL3. For example, the current measuring unit A may be an ammeter or a shunt resistor capable of measuring the charging current and the discharging current of the battery 11. The measuring unit 12 may measure the charging current of the battery 11 through the third sensing line SL3 to calculate the charge amount. In addition, the measuring unit 12 may measure the discharging current of the battery 11 through the third sensing line SL3 to calculate the discharge amount.

For example, the profile obtaining unit 110 may receive battery information about the voltage and current of the battery from the measuring unit 12. Then, the profile obtaining unit 110 may generate a charging profile CP based on the battery information.

As another example, the profile obtaining unit 110 may receive a charging profile CP from the measuring unit 12.

An external device may be connected to the positive electrode terminal P+ and the negative electrode terminal P- of the battery pack 10. For example, the external device may be a charging device or a load. In addition, the positive electrode terminal of the battery 11, the positive electrode terminal P+ of the battery pack 10, the external device, the negative electrode terminal P- of the battery pack 10, and the negative electrode terminal of the battery 11 may be electrically connected.

FIG. 11 is a drawing schematically illustrating a vehicle 1 according to still another embodiment of the present disclosure.

Referring to FIG. 11, the battery pack 10 according to an embodiment of the present disclosure may be included in a vehicle 1, such as an electric vehicle (EV) or a hybrid vehicle (HV). In addition, the battery pack 10 may drive the vehicle 1 by supplying power to a motor through an inverter provided in the vehicle 1. Here, the battery pack 10 may include the apparatus 100 for diagnosing a battery. That is, the vehicle 1 may include the apparatus 100 for diagnosing a battery. In this case, the apparatus 100 for diagnosing a battery may be an onboard device included in the vehicle 1.

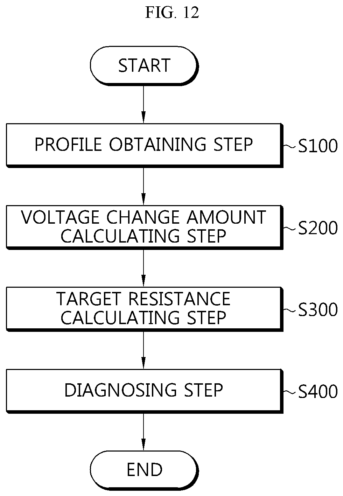

FIG. 12 is a diagram schematically showing a method for diagnosing a battery according to still another embodiment of the present disclosure.

Referring to FIG. 12, the method for diagnosing a battery may include a profile obtaining step (S100), a voltage change amount calculating step (S200), a target resistance calculating step (S300), and a diagnosing step (S400).

Preferably, each step of the method for diagnosing a battery may be performed by the apparatus 100 for diagnosing a battery. Hereinafter, for convenience of explanation, contents overlapping with the previously described contents will be omitted or briefly described.

The profile obtaining step (S100) is a step of obtaining a charging profile CP representing a voltage change of a battery in a charging process, and may be performed by the profile obtaining unit 110.

For example, the profile obtaining unit 110 may directly receive the charging profile CP of the battery from the outside. That is, the profile obtaining unit 110 may obtain the charging profile CP by being connected to the outside via wire and/or wirelessly and receiving the charging profile CP.

As another example, the profile obtaining unit 110 may receive battery information about the voltage and SOC of the battery. Then, the profile obtaining unit 110 may generate a charging profile CP based on the received battery information. That is, the profile obtaining unit 110 may obtain the charging profile CP by directly generating the charging profile CP based on the battery information.

The voltage change amount calculating step (S200) is a step of calculating a voltage change amount of the battery at a charging start point of the charging profile CP, and may be performed by the control unit 120.

For example, the control unit 120 may be configured to calculate a voltage change amount by calculating the difference between the initial voltage of the battery just before charging begins and the voltage of the battery immediately after charging begins.

The target resistance calculating step (S300) is a step of calculating a target resistance of the battery based on the calculated voltage change amount, and may be performed by the control unit 120.

The control unit 120 may calculate the target resistance in different ways when the initial SOC is the same as the target SOC and when it is different.

The control unit 120 may be configured to calculate the initial resistance based on the voltage change amount and the charging current of the charging process. Specifically, the control unit 120 may be configured to determine the initial resistance as the target resistance when the initial SOC is equal to the preset target SOC. Conversely, the control unit 120 may be configured to calculate the target resistance from the initial resistance based on a resistance table preset to represent a resistance ratio for each SOC when the initial SOC is different from the target SOC.

For example, in the embodiments of FIGS. 2 and 3, it is assumed that the charging current for the SOC section of S1 (%) to S2 (%) is I. The control unit 120 may calculate the initial resistance as a value obtained by dividing the voltage change amount (V2 - V1) by the charging current (I). Then, the control unit 120 may determine the initial resistance as the target resistance or calculate the target resistance based on the initial resistance depending on whether the initial SOC and the target SOC of the battery are the same.

The diagnosing step (S400) is a step for diagnosing a state of the battery by comparing the target resistance with a first resistance profile P1 in which the target resistance of the battery calculated in the previous charging cycle is stored, and may be performed by the control unit 120.

The control unit 120 may be configured to determine the first resistance section R1 based on the first resistance profile P1.

In addition, the control unit 120 may be configured to diagnose the state of the battery by comparing the first resistance section R1 with the target resistance. For example, the control unit 120 may be configured to diagnose the state of the battery as a normal state if the target resistance belongs to the first resistance section R1. As another example, the control unit 120 may be configured to diagnose the state of the battery as an abnormal state if the target resistance does not belong to the first resistance section R1.

The embodiments of the present disclosure described above may not be implemented only through an apparatus and a method, but may be implemented through a program that realizes a function corresponding to the configuration of the embodiments of the present disclosure or a recording medium on which the program is recorded. The program or recording medium may be easily implemented by those skilled in the art from the above description of the embodiments.

The present disclosure has been described in detail. However, it should be understood that the detailed description and specific examples, while indicating preferred embodiments of the disclosure, are given by way of illustration only, since various changes and modifications within the scope of the disclosure will become apparent to those skilled in the art from this detailed description.

Additionally, many substitutions, modifications and changes may be made to the present disclosure described hereinabove by those skilled in the art without departing from the technical aspects of the present disclosure, and the present disclosure is not limited to the above-described embodiments and the accompanying drawings, and each embodiment may be selectively combined in part or in whole to allow various modifications.

### (Explanation of reference symbols)

1: vehicle
10: battery pack
11: battery
12: measuring unit
100: apparatus for diagnosing a battery
110: profile obtaining unit
120: control unit
130: storage unit

## Claims

1. An apparatus for diagnosing a battery, comprising:
a profile obtaining unit configured to obtain a charging profile representing a voltage change of a battery in a charging process; and
a control unit configured to calculate a voltage change amount of the battery at a charging start point of the charging profile, calculate a target resistance of the battery based on the calculated voltage change amount and an initial SOC of the battery at the charging start point, and diagnose a state of the battery by comparing the target resistance with a first resistance profile in which a target resistance of the battery calculated in a previous charging cycle is stored.

2. The apparatus for diagnosing a battery according to claim 1,
wherein the control unit is configured to:
calculate an initial resistance based on the voltage change amount and a charging current of the charging process,
determine the initial resistance as the target resistance, when the initial SOC is equal to a preset target SOC, and
calculate the target resistance from the initial resistance based on a resistance table preset to represent a resistance ratio for each SOC, when the initial SOC is different from the target SOC.

3. The apparatus for diagnosing a battery according to claim 2,
wherein the resistance table is preset to correspond to a plurality of reference values for a preset reference factor, and
wherein the control unit is configured to calculate the target resistance based on a resistance table corresponding to a state value of the battery, when a state value of the battery for the reference factor is identical to any one of the plurality of reference values.

4. The apparatus for diagnosing a battery according to claim 3,
wherein the control unit is configured to select a plurality of target values adjacent to the state value of the battery among the plurality of reference values when the state value of the battery is different from the plurality of reference values, generate a target resistance table from a resistance table corresponding to the plurality of target values, and calculate the target resistance based on the target resistance table.

5. The apparatus for diagnosing a battery according to claim 2,
wherein the control unit is configured to calculate a total resistance for the battery by dividing the initial resistance by a resistance ratio corresponding to the initial SOC in the resistance table, and calculate the target resistance for the battery by multiplying the total resistance by a resistance ratio corresponding to the target SOC in the resistance table.

6. The apparatus for diagnosing a battery according to claim 1,
wherein the control unit is configured to determine a first resistance section based on the first resistance profile and diagnose the state of the battery by comparing the first resistance section with the target resistance.

7. The apparatus for diagnosing a battery according to claim 6,
wherein the control unit is configured to determine a first resistance line for a plurality of resistances included in the first resistance profile, and determine the first resistance section by adding a preset resistance threshold value to the determined first resistance line.

8. The apparatus for diagnosing a battery according to claim 6,
wherein the control unit is configured to:
diagnose the state of the battery as a normal state when the target resistance belongs to the first resistance section, and
diagnose the state of the battery as an abnormal state when the target resistance does not belong to the first resistance section.

9. The apparatus for diagnosing a battery according to claim 6,
wherein the control unit is configured to calculate a sub-voltage change amount between a voltage of the battery immediately after the charging starts and a voltage at time when the charging has been in progress for a preset time in the charging profile, calculate a sub-resistance of the battery based on the calculated sub-voltage change amount, and diagnose the state of the battery based on the target resistance and the sub-resistance.

10. The apparatus for diagnosing a battery according to claim 9,
wherein the control unit is configured to determine a second resistance section based on a second resistance profile in which a sub-resistance of the battery calculated from the previous charging cycle is stored, and diagnose the state of the battery based on the result of comparing the first resistance section with the target resistance and the result of comparing the second resistance section with the sub-resistance.

11. The apparatus for diagnosing a battery according to claim 10,
wherein the control unit is configured to determine a second resistance line for a plurality of resistances included in the second resistance profile, and determine the second resistance section by adding a preset resistance threshold value to the determined second resistance line.

12. The apparatus for diagnosing a battery according to claim 10,
wherein the control unit is configured to:
diagnose the state of the battery as a normal state when the target resistance belongs to the first resistance section or the sub-resistance belongs to the second resistance section, and
diagnose the state of the battery as an abnormal state when the target resistance does not belong to the first resistance section and the sub-resistance does not belong to the second resistance section.

13. The apparatus for diagnosing a battery according to claim 1,
wherein the control unit is configured to calculate the voltage change amount by calculating a difference between an initial voltage of the battery just before the charging starts and a voltage of the battery immediately after the charging starts.

14. A battery pack, comprising the apparatus for diagnosing a battery according to any one of claims 1 to 13.

15. A method for diagnosing a battery, comprising:
a profile obtaining step of obtaining a charging profile representing a voltage change of a battery in a charging process;
a voltage change amount calculating step of calculating a voltage change amount of the battery at a charging start point of the charging profile;
a target resistance calculating step of calculating a target resistance of the battery based on the calculated voltage change amount and an initial SOC of the battery at the charging start point; and
a diagnosing step of diagnose a state of the battery by comparing the target resistance with a first resistance profile in which a target resistance of the battery calculated in a previous charging cycle is stored.
